# EUROPÄISCHE PATENTSCHRIFT

(11) **EP 0 907 084 B1**
(45) Veröffentlichungstag und Bekanntmachung des Hinweises auf die Patenterteilung: **04.11.2009**
(21) Anmeldenummer: 98810949.2
(22) Anmeldetag: 22.09.1998
(51) Int. Cl.: G01R 15/24

(54) **Faseroptischer Spannungssensor für Freiluft-Hochspannungsanlagen**
Optical fibre voltage sensor for overhead high-voltage installations
Capteur de tension à fibre optique pour installations aériennes à haute tension

(30) Priorität: 02.10.1997 DE 19743658
(43) Veröffentlichungstag der Anmeldung: 07.04.1999
(73) Patentinhaber: ABB Research Ltd., 8050 Zürich (CH)
(72) Erfinder: Bohnert, Klaus, Dr., 5443 Niederrohrdorf (CH); Brändle, Hubert, Dr., 8102 Oberengstringen (CH); Gabus, Philippe, 5413 Birmenstorf (CH); Kostovic, Jadran, 5430 Neuenhof (CH); Talir, Jiri, 8107 Buchs (CH)
(74) Vertreter: ABB Patent Attorneys

(56) Entgegenhaltungen:
- EP-A- 0 433 824
- EP-A- 0 789 245
- WO-A-97/01100
- DE-A- 19 548 467
- MATHIS M ET AL: "OPTISCHE SENSOREN FUER HOCHSPANNUNGSSCHALTANLAGEN" ELEKTROTECHNISCHE ZEITSCHRIFT - ETZ,DE,VDE VERLAG GMBH. BERLIN, Bd. 117, Nr. 18, 1996, Seite 40-43 XP000638295 ISSN: 0948-7387

## Beschreibung

### TECHNISCHES GEBIET

Die Erfindung bezieht sich auf das Gebiet der optischen Messung elektrischer Spannungen. Sie geht aus von einem faseroptischen Spannungssensor mit einem piezoelektrischen Sensorelement .

### STAND DER TECHNIK

Ein faseroptischer Spannungssensor der eingangs genannten Art ist z. B. aus der EP 0 316 635 B1 bekannt. Das Sensorprinzip beruht darauf, dass eine durch ein elektrisches Feld induzierte Dehnung eines piezoelektrisch Sensorkörpers auf eine Faser übertragen und deren Längenänderung interferometrisch detektiert wird. Häufig wird Quarz als Piezomaterial eingesetzt. Für die interferometrische Messung sind verschiedene Arten von Glasfaser - Interferometern, wie z. B. ein Mach - Zehnder, ein Fabry - Perot oder ein Zweimoden - Faserinterferometer, verwendbar. Aus der EP 0 529 339 A1 ist es bekannt, zwei durch eine störunempfindliche Monomodefaser getrennte Zweimoden - Faserinterferometer nach Art eines Tandem - Interferometers hintereinanderzuschalten. Das Tandem - Interferometer wird in Transmission oder, gemäss der EP 0 569 700 A2, in Reflexion betrieben. Eine Variante mit einer polarimetrischen Sensorfaser anstelle einer Zweimoden - Sensorfaser ist in der DE 196 05 717 C1 offenbart. Aus der DE 41 15 370 A1 ist es auch bekannt, die Längenänderung einer Zweimodenfaser mit Hilfe des Guoy - Effektes zu detektieren.

Zur Kompensation der Temperaturabhängigkeit des faseroptischen Spannungssensors werden verschiedene Methoden angewendet. In der EP 0 433 824 B1 wird vorgeschlagen, die piezoelektrischen Sensor- und Demodulatorelemente gleich aufzubauen und bei gleicher Temperatur zu betreiben. In der DE 42 29 449 werden für diesen Zweck spezielle Quarzschnitte und Faserbefestigungen angegeben, für welche der Temperaturgang des Piezoeffektes eliminierbar ist. Die nicht vorveröffentlichte deutsche Patentanmeldung mit dem Aktenzeichen 197 01 221. 3 zeigt auf, dass in einem Zweimoden - Faserinterferometer die Sensortemperatur aus dem Interferenzkontrast bestimmt und ihr Einfluss auf das Sensorsignal kompensiert werden können.

Eine selektive Messung einer einzigen E - Feldkomponente ist gemäss der EP 0 316 619 B1 durch spezielle Kristallklassen, Orientierungen und Formen des piezoelektrischen Körpers sowie durch die Art der Faserbefestigung realisierbar. In der zuoberst zitierten EP 0 316 635 B1 wird zudem offenbart, dass durch Aneinanderreihung solcher richtungsempfindlicher Sensorelemente mit dielektrischen Zwischenstücken ein das lokale E- Feld integrierender Spannungssensor approximiert werden kann.

Im Stand der Technik sind auch verschiedene Varianten zur Integration eines faseroptischen Spannungswandlers in einer Gasisolierten Schaltanlage (GIS) veröffentlicht. Die DE 40 25 911 A1 zeigt für eine einphasige GIS, dass die Hochspannung zuverlässig durch lokale Feldmessungen mit mehreren Sensorelementen bestimmt werden kann, die auf der Innenseite der GIS Kapselung über den Umfang verteilt angeordnet sind. Hingegen wird in der deutschen Schrift mit dem Aktenzeichen DE 196 04 908 A1 eine Spannungsmessung in einer dreiphasigen GIS dadurch realisiert, dass in jeder Phase ein Quarzzylinder mitsamt seiner Faserbewicklung die ganze Hochspannung überbrückt. Zur Isolation der sehr hohen E - Feldstärken sind die drei Spannungssensoren vollständig in die SF₆ - Überdruckatmosphäre der GIS eingetaucht. Zusätzlich ist ein Isolatorrohr zum Schutz der Quarzzylinder und Sensorfasern vor chemisch aggressiven Gasen vorgesehen. Desweiteren wird in der DE 195 48 467 A1 eine mechanisch störunempfindliche Aufhängung des faseroptischen Spannungssensors gezeigt, bei der axiale Kräfte beidseitig antisymmetrisch auf die Endflächen des Quarzylinders wirken, so dass die über die Zylinderlänge gemittelte Faserdehnung verschwindet.

Bisher wurde noch kein faseroptischer Spannungssensor angegeben, der zur Hochspannungsmessung in Freiluft geeignet wäre und nur einige wenige integrierende Sensorelementen aufweist. In Freiluft durchgeführte lokale Feldmessungen sind oft völlig unzureichend, da die E - Feldverteilungen je nach Wetter und Schaltungszustand benachbarter Freiluftschalter stark variieren. In der W097/01100 A1 wird ein faseroptischer Spannungssensor beschrieben, der auf Grund seiner Aussenumhüllung aus Polymermaterial für Freiluft geeignet ist. Im Inneren weist der Sensor eine helixförmige gewundene optische Faser auf. Diese Faser muss über ihre ganze Länge die volle Potentialdifferenz, welche sich zwischen den beiden entfernten Enden des Spannungssensors ausbildet überbrücken. Es ist aber sehr aufwendig, die gesamte Potentialdifferenz mit einem mehrere Meter langen approximierenden Spannungssensor gemäss der EP 0 316 635 B1 zu überbrücken. Eine ausreichende Integrationsgenauigkeit würde sehr viele Sensorelemente erfordern. Gleichwohl würde die Gesamtspannung auf die Sensor- und Zwischenelemente aufgeteilt, sodass ein veränderliches dielektrisches Verhalten der Zwischenelemente den Spannungsabfall über die Sensorelemente und damit die Messgenauigkeit verfälschen würde.

Eine flexible Aufhängung von Thyristor - Stromrichtern für Öl- oder Gasplattformen oder zum Schutz vor Erdbeben ist aus der DE 3 010 294 C2 bekannt. Dabei sind mehrere Stromrichter nebeneinander über Isolatoren an einem Joch befestigt und bei Bedarf mit dem Boden über Isolatoren in Reihe zu Dämpfungselementen verspannt. Die Konstruktion ist ersichtlicherweise nicht für Hochspannungen ausgelegt.

Schliesslich gibt es einen breiten Stand der Technik bezüglich Stromsensoren mit einem potentialgetrennten Sensorkopf. Dazu gehören insbesondere magnetooptische Stromsensoren mit einem Glasblock - Sensorkopf oder einer Sensorfaser (s. z. B. die nicht vörveröffentlichten deutschen Patentanmeldungen mit den Aktenzeichen 196 21 654.0 und 197 03 128.5), aber auch hybrid - optische,Stromsensoren mit einem elektronischen Sensorkopf auf Hochspannungspotential und optischer Leistungsversorgung und Signalübertragung.

### DARSTELLUNG DER ERFINDUNG

Aufgabe der vorliegenden Erfindung ist es, einen faseroptischen Spannungssensor anzugeben, welcher zur Hochspannungsmessung in Freiluft geeignet ist und sich durch einen einfachen, schlanken und robusten Aufbau und eine sehr hohe Messgenauigkeit auszeichnet. Diese Aufgabe wird erfindungsgemäss durch die Merkmale des Anspruchs 1 gelöst.

Kern der Erfindung ist es nämlich, einen faseroptischen Spannungssensor aus mehreren E - Feld integrierenden Sensorelementen und elektrisch leitfähigen Abstandselementen aufzubauen und ein freilufttaugliches Hochspannungsteil des Spannungssensors dadurch zu bilden, dass die Anordnung der Sensor- und Abstandselemente von einem hochspannungsfesten Dielektrikum umgeben und mit einer Schutzbeschirmung versehen ist.

Ein Ausführungsbeispiel zeigt den Innenaufbau eines 420 kV - Hochspannungssensors mit mehreren piezoelektrischen Sensorelementen, die über elektrisch leitfähige Abstandselemente und flexible Halterungen miteinander und mit den Anschlusskontakten verbunden sind.

Ein weiteres Ausführungsbeispiel betrifft die dielektrische Sensorverpackung, die als Dielektrikum vorzugsweise eine Elastomer - Vergussmasse aus Polyurethan oder Silikon und als Schutzbeschirmung einen Silikonschirm mit Stützisolator aufweist.

Ein anderes Ausführungsbeispiel zeigt den faseroptischen Spannungssensor mit einem integrierten Stromsensor und einem Hochspannungsteil, das in der Nähe eines Hochspannungsfreiluftschalters am Stromleiter hängend montiert ist.

Zusätzliche Ausführungsbeispiele ergeben sich aus den abhängigen Ansprüchen.

Ein wichtiger Vorteil des erfindungsgemässen Spannungssensors besteht darin, dass die gesamte Hochspannung nur über die integrierenden Sensorelemente abfällt, wodurch eine hervorragende Integrations- und Messgenauigkeit erzielt wird.

Ein weiterer Vorteil des Spannungssensors besteht darin, dass durch seinen langgestreckten Aufbau, insbesondere in der Form eines kapazitiven Spannungsteilers, eine Steuerung der Feldverteilung über die Sensorelemente, in der dielektrischen Verpackung und in der umgebenden Freiluft möglich ist.

Sehr vorteilhaft ist auch die einfache Skalierbarkeit des Spannungssensors zu anderen Spannungsebenen, da die Gesamtlänge und der Durchmesser sowie die Anzahl, Länge und Position der Sensorelemente leicht anpassbar sind.

Andere Vorteile des Spannungssensors betreffen die Kompaktheit, das niedrige Gewicht, die Wartungsfreiheit, die einfache Kombinierbarkeit mit optischen Stromsensoren und die tiefen Herstellungskosten.

### KURZE BESCHREIBUNG DER ZEICHNUNG

Die Erfindung wird nachstehend anhand von Ausführungsbeispielen erläutert. Es zeigen:
- Fig. 1: einen Innenaufbau eines erfindungsgemässen faseroptischen Hochspannungssensors mit vier faserbewickelten Quarzzylindern als Sensorelementen und fünf Metallzylindern als Abstandselementen;
- Fig. 2: Detailansicht einer flexiblen Halterung zwischen einem Sensorelement und einem Abstandselement;
- Fig. 3: hochspannungsfeste, dielektrische Verpackungen für einen faseroptischen Spannungssensor gemäss Fig. 1;
- Fig. 4: Gesamtaufbau eines faseroptischen Spannungssensor gemäss den Fig. 1 - 3 für die 420 kV - Klasse;
- Fig. 5: Äquipotentiallinien - Verteilung eines faseroptischen Spannungssensors gemäss Fig. 4;
- Fig. 6: hängende Montage eines faseroptischen Spannungssensors gemäss Fig. 4 mit einem integrierten optischen Stromsensor;

In den Figuren sind gleiche Teile mit gleichen Bezugszeichen versehen.

### WEGE ZUR AUSFÜHRUNG DER ERFINDUNG

Die Erfindung hat einen faseroptischen Hochspannungssensor für Freiluftanwendungen zum Gegenstand. In Freilufthochspannungsanlagen müssen Spannungen bis zu mehreren 100 kV mit grosser Genauigkeit gemessen werden. Die dielektrische Festigkeit eines Sensors muss darüberhinaus auch bei Blitzstoss- und Schaltstossspannungen gewährleistet sein, die weit höher liegen können. Der Aufbau und die dielektrische Verpackung des Hochspannungssensors werden beispielhaft anhand einer Sensorauslegung für 420 kV Freiluftschaltanlagen dargestellt. Bezüglich des zugrundeliegenden Messprinzips wird auf die angeführten Schriften, insbesondere die EP 0 316 619 B1, EP 0 316 635 B1, EP 0 529 339 A1 und EP 0 569 700 A2, verwiesen. In einer bevorzugten Konfiguration wird an die Endflächen 2a, 2b eines mit einer Zweimoden - Sensorfaser 4a unter konstanter Ganghöhe bewickelten Quarzzylinders 3, dessen Achse parallel zur kristallographischen x - Achse liegt, eine Wechselspannung gelegt, piezoelektrisch eine periodische Umfangsänderung induziert, die resultierende Faserdehnung in eine Modulation der Phasendifferenz der beiden räumlichen optischen Moden (LP₀₁ und gerader LP₁₁ Modus) umgesetzt, die Wellenfronten beider Moden interferenzfrei über eine Einmoden - Verbindungsfaser 4b zu einer Zweimoden - Empfangsfaser übertragen und an deren Ende das Interferenzmuster detektiert. Die Phasen- bzw. Intensitätsmodulation ist dann proportional zur Messspannung. Die Intensitätsmodulation kann mit Hilfe eines elektronischen Regelkreises und einem oder mehreren piezoelektrischen Modulatoren an der Empfangsfaser kompensiert werden, so dass die Regelspannung ein exaktes negatives Abbild der Messspannung liefert. Mit Vorteil wird die Sende- und Empfangsoptik zusammen mit der Messelektronik in einer optoelektronischen Messapparatur 7 zusammengefasst.

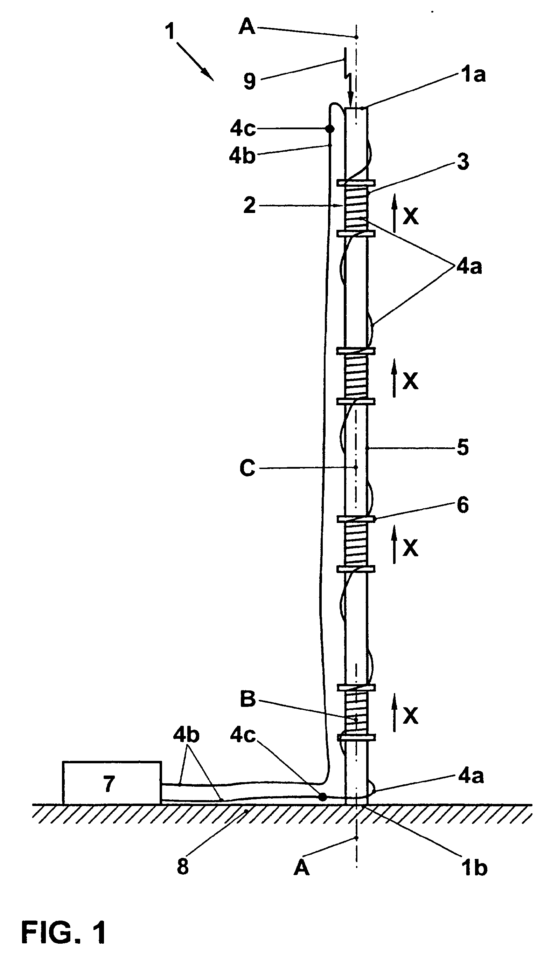

Fig. 1 zeigt nun einen erfindungsgemässen Aufbau eines faseroptischen Hochspannungssensor 1 mit vier identischen Sensorelementen 2, die über Abstandselemente 5, insbesondere Metallzylinder 5 und Halterungen 6, miteinander und mit den Anschlusskontakten 1a, 1b elektrisch leitend verbunden sind. Die Sensorelemente 2 bestehen aus Quarzzylindern 3, deren kristallographische x - Achsen gleich orientiert sind und die mit einer durchgehenden Sensorfaser 4a gleichmässig und vollständig bewickelt sind. Gleiche Orientierung bedeutet, dass für ein rechtshändiges Koordinatensystem die positiven x - Richtungen bei gleicher (entgegengesetzter) Händigkeit der Quarze zum gleichen (entgegengesetzten) Anschlusskontakt 1a, 1b weisen. Die Sensorachse A erstreckt sich vom Erdpotential 8 bis zum Hochspannungpotential 9 und definiert zwischen den Anschlusskontakten 1a, 1b einen Integrationspfad, der im Bereich der Quarzzylinder 3 durch die Längs- bzw. Körperachsen B verläuft. Die Sensorfaser 4a ist über Spleisse 4c und Verbindungsfasern 4b an die Messapparatur 7 angeschlossen.

Die erfindungsgemässe Sensoranordnung 2, 5 zeichnet sich dadurch aus, dass die Hochspannung einerseits über die ganze Sensorlänge von mehreren Metern verteilt wird, was Voraussetzung für die dielektrische Steuerung der elektrischen Feldstärken in Freiluft ist, und andererseits die gesamte Hochspannung ausschliesslich über die Einzelquarze 3 abfällt, so dass die Teilspannungen durch exakte E - Feldintegration bestimmbar sind.

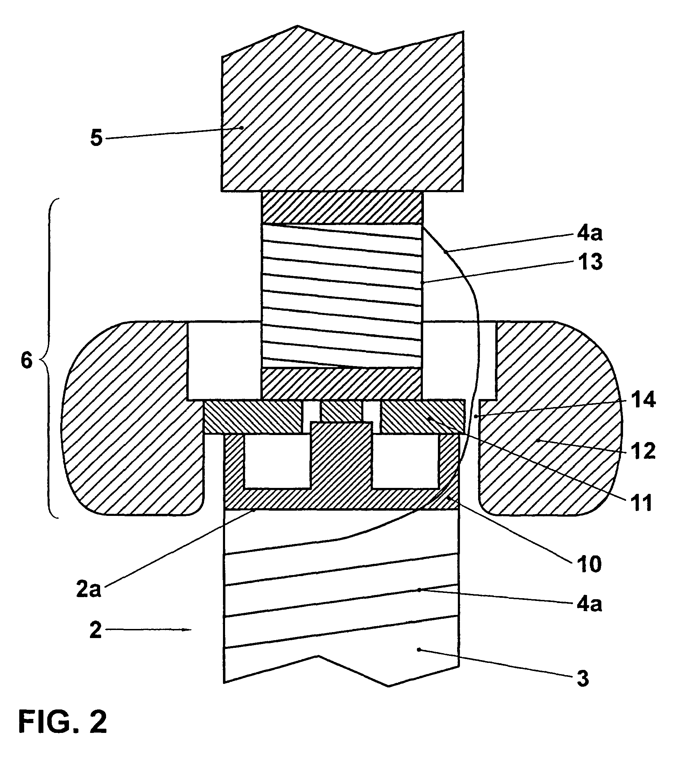

In Fig. 2 ist ein Ausführungsbeispiel einer elektrisch leitfähigen und mechanisch flexiblen Halterung 6 dargestellt. Auf die Endfläche 2a, 2b eines Quarzzylinders 3 ist eine Innenlektrode 10 gleichen Durchmessers und ähnlicher thermischer Ausdehnung mit einem elektrisch leitfähigen Kleber geklebt. Die Innenelektrode 10 ist elektrisch leitfähig über eine Zwischenplatte 11 mit einer Steuerelektrode 12 aus Aluminium und mit einem Federelement 13 verschraubt. Die Zwischenplatte 11 weist eine Aussparung 14 zur Durchfädelung der Sensorfaser 4a auf. Die Steuerelektrode 12 dient zur Steuerung der Feldverteilung über den Quarzzylinder 3. Das Federelement 13 schafft eine axial und auch lateral flexible Verbindung zum benachbarten Metallzylinder 5. Dadurch wird die gesamte Sensoranordnung in Längs- und Querrichtung elastisch, unterschiedliche thermische Ausdehnungen der Sensoranordnung 2, 5 und seiner dielektrischen Verpackung werden kompensiert und die Quarzzylinder 3 sind vor mechanischen Belastungen geschützt. Bevorzugt werden alle Federelemente 13 gleich gewählt, um eine besonders störunempfindliche symmetrische Aufhängung zu realisieren.

Selbstverständlich sind andere, insbesondere starre, Ausführungsformen der Halterungen 6 auch möglich. Es ist jedoch aus dielektrischen Gründen wünschenswert, dass die Halterungen 6 elektrisch leitfähig sind und die Innenelektroden 10 mit den Endflächen 2a, 2b der Quarzzylinder 3 in einer form- und stoffschlüssigen Verbindung stehen.

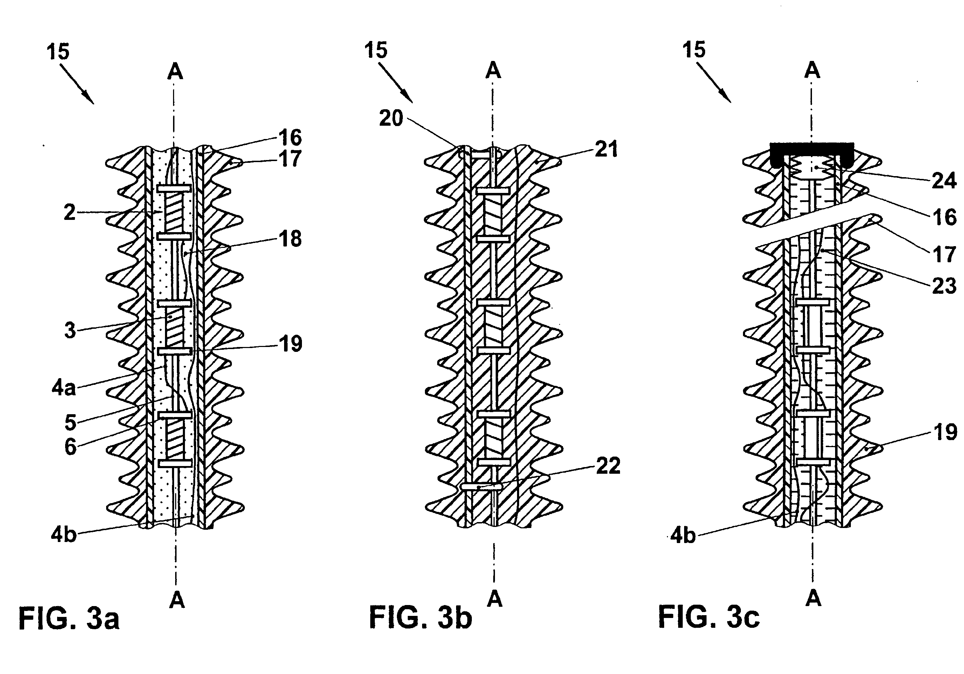

In Fig. 3 sind drei Ausführungsbeispiele zur dielektrischen Verpackung des Spannungssensors 1 angegeben. Zur Bildung eines freilufttauglichen Hochspannungsteils 15 des Spannungssensors 1 ist es erforderlich, dass die Anordnung der Sensor- und Abstandselemente 2, 5 von einem hochspannungsfesten Dielektrikum 18, 21, 23 umgeben und mit einer Schutzbeschirmung 16, 17, 20, 21 versehen ist. Insbesondere besteht das Dielektrikum aus einem Elastomer 18, 21, einer Isolatorflüssigkeit 23 oder eventuell einem Isoliergas und die Schutzbeschirmung 16, 17, 20, 21 aus einem Elastomer 17, 21 mit einem zusätzlichen Stützisolator 16, 20. Alternativ zur Schutzbeschirmung 16, 17, 20, 21 ist auch ein Porzellanisolator einsetzbar.

Im Detail zeigt Fig. 3a eine Sensoranordnung 2, 5, die innerhalb eines Hochspannungsisolatorrohres 16 montiert ist. Das Isolatorrohr 16 besteht vorzugsweise aus einem faserverstärkten Kunststoff und ist mit einem gerippten Silikonschirm 17 vergossen, der einen ausreichend langen Kriechweg zwischen Erd- und Hochspannungspotential 8, 9 aufweist. Die Sensoranordnung 2, 5 ist im Rohr 16 mit Hilfe von Halterungsstiften 19 für die Steuerelektroden 12 zentriert und mit Polyurethan 18 vergossen.

Das Problem beim Polyurethanverguss besteht darin, eine giessfähige Polyurethanmischung so zu wählen, dass die ausgehärtete Polyurethan - Vergussmasse 18 eine geringe Härte im relevanten Temperaturbereich, z. B. zwischen -40 °C und 85 °C, und dennoch eine ausreichende Durchschlagsfestigkeit aufweist. Vorzugsweise werden ein Harz und ein Härter der Polyurethanmischung so gewählt, dass die Shore-Härte A der Polyurethan - Vergussmasse 18 bei Raumtemperatur einen Wert kleiner als 18 hat. Die Polyurethanmischung wird in flüssiger Form in das Rohr 16 mit der vormontierten Sensoranordnung 2, 5 eingefüllt und härtet bei Raumtemperatur innerhalb von ein bis zwei Tagen aus. Der mechanische Stress, den die Polyurethan - Vergussmasse 18 auf die Glasfasern 4a, 4b und insbesondere auf die Sensorfaser 4a ausübt, ist dann klein und verändert die optischen Eigenschaften der Fasern 4a, 4b nicht störend. Die Polyurethan - Vergussmasse 18 besitzt ausserdem eine relativ hohe Kompressibilität und kann deshalb die eigene thermische Ausdehnung im Rohr 16 problemlos kompensieren. Insgesamt wird so eine mit der Faseroptik kompatible, dielektrisch belastbare und mechanisch stabile Verpackung realisiert.

Fig. 3b zeigt eine Ausführungsform, bei welcher das Dielektrikum und die Schutzbeschirmung aus einer Silikon - Vergussmasse in der Form eines gerippten Silikonkörpers 21 bestehen und der Silikonkörper 20, 21 mindestens einen Isolatorstab 20 aus einem faserverstärkten Kunststoff aufweist. Die Sensoranordnung 2, 5 ist an dem Isolatorstab 20 mit Fixierungen 22 befestigt.

Der Silikon - Verguss erfolgt in einer schirmförmigen Gussform, die nach der Aushärtung wieder entfernt wird. Es resultiert ein selbsttragender Silikonkörper 21, der durch den mindestens einen Isolatorstab 20 mechanisch verstärkt ist und dessen Beschirmung einen ausreichend langen Kriechweg aufweist. Die Shore-Härte der ausgehärteten Silikon - Vergussmasse 21 muss wiederum ausreichend tief gewählt werden. Vorzugsweise wird eine Silikonsorte verwendet, die nahe bei Raumtemperatur vernetzt. Dadurch wird der mechanische Stress vermieden, der in Silikonen mit hoher Vulkanisierungstemperatur von typisch 130 °C bis 150 °C durch thermische Kontraktion beim Abkühlen entsteht. Diese Sensorverpackung ist kostengünstiger als das Vergiessen der Sensoranordnung 2, 5 in einem Isolatorrohr 16. Jedoch ist die mechanische Stabilität geringer. Deshalb ist diese Lösung vor allem für kleinere Spannungsebenen geeignet, bei denen das Hochspannungsteil 15 entsprechend kürzer ist.

Fig. 3c zeigt schlieslich eine Variante zu Fig. 3a, bei welcher anstelle der Polyurethan - Vergussmasse 18 ein Transformatoren- oder Silikonöl 23 verwendet wird. Hier sind zusätzlich ein Faltenbalg bzw. Druckausgleichselement 24 zur Kompensation der thermischen Ausdehnung des Öls 23 sowie öldichte Faserdurchführungen 28 notwendig. Grundsätzlich ist auch eine gasdichte Variante mit SF₆ oder N₂ unter Druck oder Druckluft als Dielektrikum denkbar. Ein fluides Medium 23 übt keinerlei Stress auf die Glasfasern 4a, 4b aus, muss aber wegen der Leckagegefahr gegebenenfalls überwacht werden.

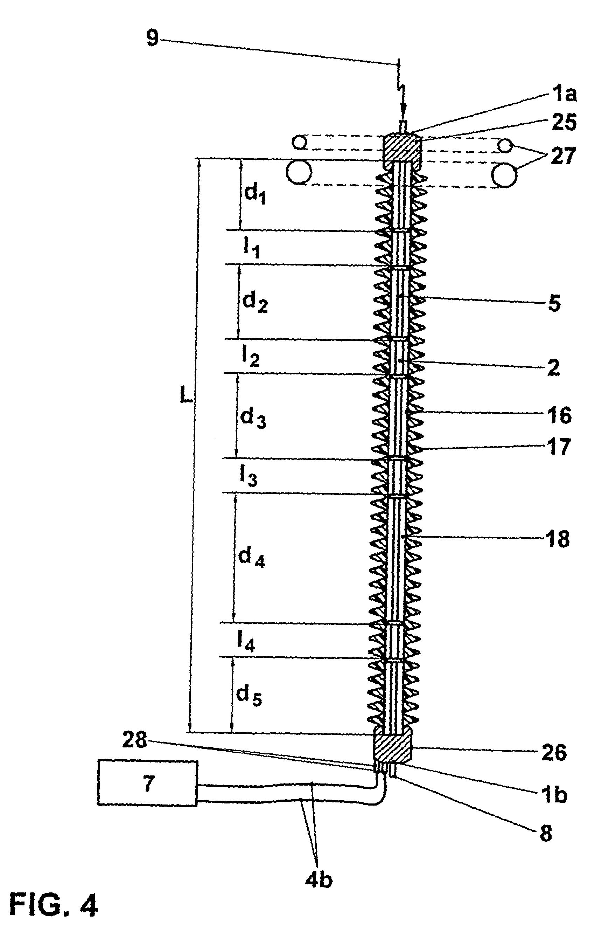

In Fig. 4 ist der Gesamtaufbau des Spannungssensors 1 gemäss der Variante Fig. 3a für eine Spannungsebene von 420 kV Phase-zu-Phase bzw. 242 kV effektiv Phase-zu-Erde dargestellt. Das Isolatorrohr 16 ist beidseitig mit metallischen Flanschen 25, 26 versehen, die zur Befestigung der Sensoranordnung 2, 5 und zur Montage sowie als Anschlusskontakte 1a, 1b des Hochspannungsteils 15 dienen. Der erdseitige Flansch ist zudem mit Faserdurchführungen bzw. Fasersteckern 28 für die Zu- und Rückleitungsfasern 4b des Sensors 1 ausgerüstet. Der Einfachheit halber sind die Glasfasern 4a, 4b im Hochspannungsteil 15 nicht dargestellt.

Das Isolatorrohr 16 hat eine Gesamtlänge L = 3,20 m. Der Sensor 1 umfasst vier Quarzzylinder 3 mit 30 mm Durchmesser und einer Länge l₁ = l₂ = l₃ = l₄ = 150 mm sowie fünf Abstandselemente 5 mit Längen d₁ = 400 mm, d₂ = 425 mm, d₃ = 575 mm, d₄ = 750 mm und d₅ = 450 mm. Es ist vorteilhaft, wenn bei gegebener Gesamtlänge L diese Längen der Sensor- und Abstandselemente 2, 5 in einem Bereich von ca. ± 5% eingehalten werden. Zur globalen Steuerung der elektrischen Feldverteilung können ein oder mehrere hochspannungsseitige und/oder erdseitige Korona- und/oder Potentialsteuerungsringe 27 verwendet werden. Jeder Quarz 3 sieht dann etwa ein Viertel der Gesamtspannung.

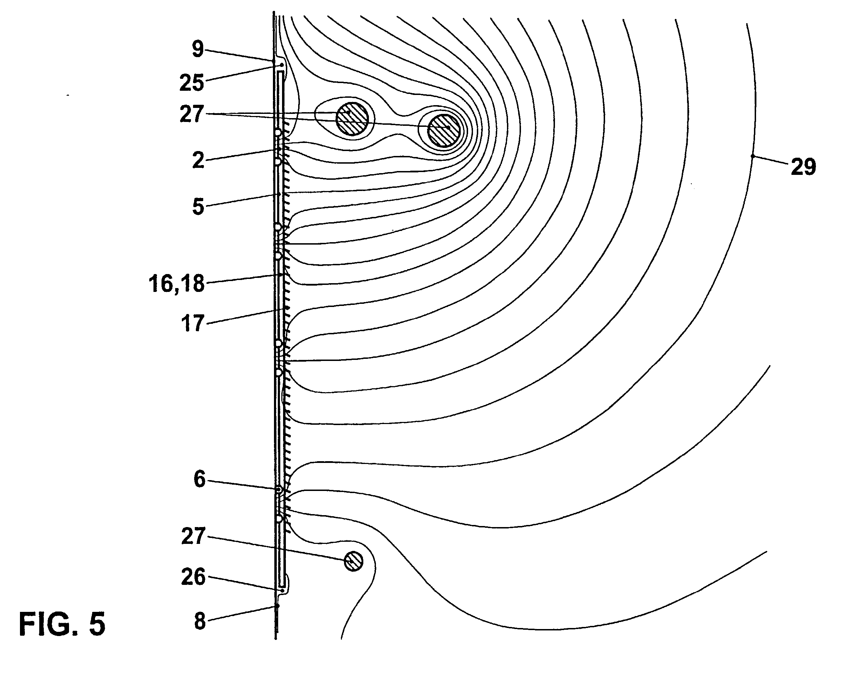

Aus Fig. 5 ist die Verteilung der Äquipotentiallinien 29 in der rechten Halbebene ersichtlich. Die höchsten dielektrischen Belastungen treten unmittelbar an den Quarzkristallen 3 und hier insbesondere in Nähe der Elektroden 10, 12 auf. Von den Sensorelelementen 2 ausgehend nehmen die Potentialliniendichte und die elektrische Feldstärke radial nach aussen ab. Der Durchmesser des Hochspannungsteils 15, insbesondere des Isolatorrohres 16 und der Silikonbeschirmung 17, ist nun so zu wählen, dass die Feldstärke in der Luft unter den zulässigen Grenzwerten bleibt. Für das in Fig. 4 gezeigt Beispiel wird dies mit Aussendurchmessern des Isolatorrohres 16 von mindestens 90 mm und der Silikonbeschirmung 17 von mindestens 200 mm erreicht. Ein derart aufgebauter 420 kV - Prototyp hat die Hochspannungstests, insbesondere 1425 kV Blitzstoss, 1050 kV Schaltstoss und 1 Minute 520 kV effektive Wechselspannung, erfolgreich bestanden. Die zulässigen Grenzwerte der E - Feldstärken in Luft betragen dabei für Blitzstoss 25 kV/cm und für effektive Wechselspannung 3,5 kV/cm.

Eine Anpassung des Spannungssensors 1 gemäss der Fig. 4, 5 an höhere oder tiefere Spannungsebenen ergibt sich unmittelbar aus dem Gesagten, indem die Gesamtlänge und der Durchmesser des Hochspannungsteils 15, die Anzahl, Länge, Position und der Durchmesser der Sensorelemente 2 sowie gegebenenfalls Korona- und Potentialsteuerungsringe 27 so dimensioniert werden, dass eine ungefähr gleichmässige dielektrische Belastung der Sensorelemente 2 resultiert und die Grenzwerte für die Feldstärken im Hochspannungsteil 15 und in Freiluft eingehalten sind. Günstigerweise sind die Länge der Sensorelemente 2 gleich und ihre Abstände zum Erdpotential 8 hin zunehmend gewählt. Die wesentlichen Dimensionierungskriterien können dem Ausführungsbeispiel für die 420 kV - Klasse entnommen werden. Beispielsweise beträgt die Sensorlänge L ≈ 1,3 m pro 100 kV effektiver Betriebsspannung Phase-zu-Erde und die gesamte Quarzlänge l₁ + .. + lₙ (n = Anzahl Quarze 3) beträgt davon ungefähr ein Fünftel.

Ein wichtiger Vorteil des erfindungsgemässen Freiluft - Spannungssensors 1 gegenüber konventionellen Spannungswandlern besteht darin, dass der Isolationsaufwand aufgrund der Längserstreckung und des kleinen Durchmessers der Sensoranordnung 2, 5 massiv reduziert werden kann. Dadurch sind eine kostengünstige dielektrischen Verpackung, eine schlanke Gestalt und ein deutlich reduziertes Gewicht realisierbar. Ferner resultieren eine verbesserte Handhabbarkeit und vielseitige Montierbarkeit des Freiluft - Spannungssensors 1.

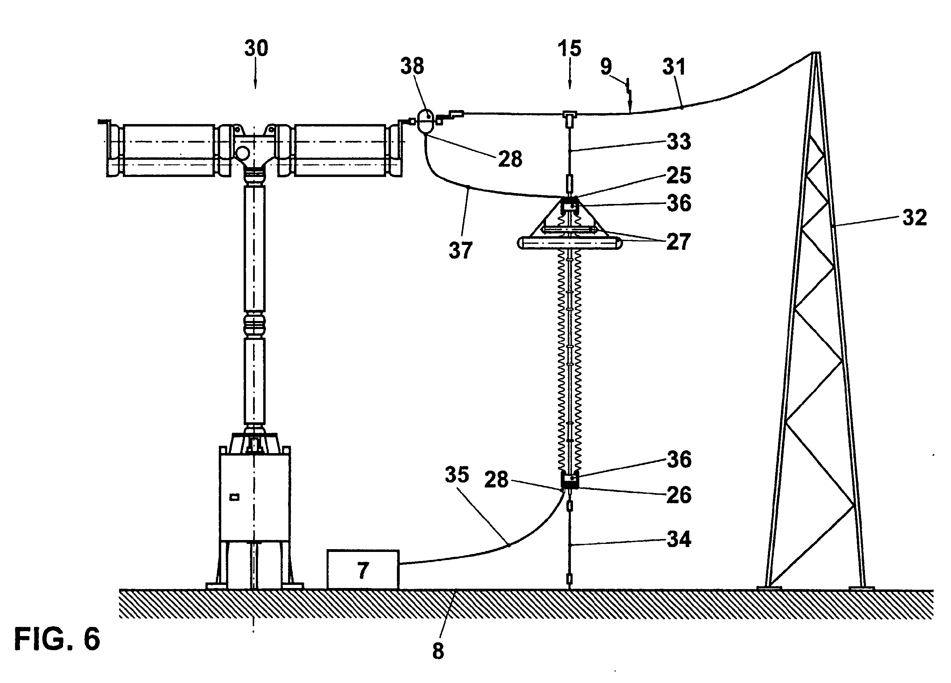

Fig. 6 zeigt eine Installation des 420 kV - Spannungssensors 1 und seine Kombination mit einem (hybrid-) optischen Stromsensor 38. Vorzugsweise ist der Sensor 1 in der Nähe eines Hochspannungsfreiluftschalters 30 an einem Stromleiter 31 hängend montiert. Das Hochspannungsteil 15 umfasst eine Aufhängevorrichtung 33, ein Erdungs- und Verankerungskabel 34 und insbesondere mindestens einen Korona- und/oder Potentialsteuerungsring 27. Die Aufhängevorrichtung 33, die Ringe 27 und der obere Flansch 25 des Isolatorrohres 16 liegen auf Hochspannungspotential 9. Der untere Flansch 26 liegt auf Erdpotential 8 und wird mit dem Kabel 34 am Boden verankert.

Eine hängende Montage hat den Vorteil, dass kein Fundament benötigt wird und geringere Anforderungen an die Stabilität des Hochspannungsteils 15, insbesondere des Stützisolators 16, 20, gestellt werden. Durchbiegungen des langen Isolators 16, 20 können dann z. B. bei hohen Windstärken auftreten. Sie werden jedoch von den elastischen Halterungen 6 aufgefangen, so dass die Sensorelemente 2 mechanisch unbelastet bleiben. Die Silikonbeschirmung 17, 21 ist allwettertauglich und garantiert auch bei Feuchtigkeit und Nässe ausreichende Kriechwege.

Die optischen Verbindungsfasern 4b des Spannungssensors 1 werden in einem witterungsfesten Kunststoffschlauch bzw. Faserkabel 35 vom erdseitigen Flansch 26 zur Messapparatur 7 geführt. Der optische Stromsensor 38 sitzt am rechten Schalterende und umschliesst den Stromleiter 31. Seine optischen Zuführungsfasern sind in einem weiteren Faserkabel 37 vom Stromsensor 38 zum hochspannungsseitigen Flansch 25 geführt und überbrücken innerhalb des Hochspannungsteils 15 die Potentialdifferenz zwischen der Hochspannung 9 und der Erde 8. Im Hochspannungsteil 15 können die Zuführungsfasern für den Stromsensor 38 im Polyurethan 18 oder Silikon 17, 21 mitvergossen oder im Öl 23 verlegt sein. Erdseitig sind sie vorzugsweise im Faserkabel 35 verlegt und mit einer in der Messapparatur 7 integrierten Detektionseinheit verbunden. Bevorzugt weisen der Erdflansch 26 und der Stromsensor 38 Faserstecker 28 und der Hochspannungsflansch 25 einen Faserstauraum 36 für das Faserkabel 37 auf. Als Stromsensor 38 ist jeder potentialgetrennte, d. h. nur über optische Fasern verbundene, Stromsensor 38 einsetzbar.

Vorteilhaft an dem optischen Freiluft - Kombisensor 1, 38 sind u. a. der modulare Aufbau aus Stromsensor 38, Hochspanungsteil 15 und Messapparatur 7, die einfache Anschliessbarkeit über freihängende, lösbare Faserkabel 35, 37 und die Installierbarkeit der Messapparatur 7 in grosser Distanz ausserhalb der Hochspannungsumgebung.

Der erfindungsgemässe Freiluft - Hochspannungssensor 1 ist weder auf die Verwendung eines Zweimodenfaser - Tandeminterferometers noch auf faserbewickelte Quarzzylinder 3 als Sensorelemente 2 beschränkt. Vielmehr ist als optische Detektionsmethode für die Faserdehnung jedes der eingangs genannten Glasfaser - Interferometer geeignet. Die Faserkonfiguration ist dann im Hochspannungsteil 15 entsprechend anzupassen. Die Sensorfaser 4a kann auch bifilar gewickelt sein, oder die rückführende Verbindungsfaser 4b kann im Hochspannungsteil 15 unterbracht oder vergossen sein. Insbesondere entfällt in Reflexionsanordnungen eine der Verbindungsfasern 4b. Ebenfalls kann eine der genannten Methoden zur Temperaturkompensation angewendet werden. Grundsätzlich kann jedes Sensorelement 2 mit einem eigenen Glasfaser - Interferometer ausgestattet sein. Ein Gesamtspannungssignal ist dann aus den einzelnen, kalibrierten Interferometersignalen bestimmbar.

Die vielfältigen Möglichkeiten zur Ausgestaltung E - Feld integrierender Sensorelemente 2 mit verschwindender transversaler E - Feldempfindlichkeit sind in den EP 0 316 635 B1 und EP 0 316 619 B1 dargelegt. In der Praxis sind auch Sensorelemente 2 mit nichtverschwindender transversaler E - Feldempfindlichkeit zulässig, da transversale E - Felder durch die erfindungsgemässe Feldsteuerung 10, 12, 27 sehr klein gehalten werden können. Es ist somit erfindungswesentlich, dass das mindestens eine Sensorelement 2 einen piezoelektrischen Körper 3 und eine daran befestigte Sensorfaser 4a umfasst. Darüberhinaus ist es wünschenswert, dass die Sensorfaser 4a mit einem vorgebbaren Längenabschnitt so an dem Körper 3 befestigt ist, dass sie Längenänderungen nur durch E - Feldkomponenten parallel zur Sensorachse A erfährt. Wenn der Spannungssensor 1 mindestens zwei Sensorelemente 2 mit einer durchgehenden Sensorfaser 4a aufweist, soll für eine hohe Integrationsgenauigkeit jedes Sensorelement 2 einen zu seiner Länge proportionalen Verstärkungsfaktor besitzen, welcher der piezoelektrisch induzierten Längenänderung der Sensorfaser 4a entspricht.

Im folgenden werden nochmals kurz einige wichtige Beispiele für E - Feld integrierende Sensorelemente 2 mit exakt verschwindender transversaler E - Feldempfindlichkeit erwähnt. Beispiele für scheibenförmige glasfaserumwickelte Piezokörper 3 sind PVDF (Polyvinylfluorid), das entlang der Scheibennormalen in z - Richtung elektrisch gepolt und in y - Richtung mechanisch gereckt wurde, desweiteren eine piezoelektrische Keramik, z. B. PZT, oder LiNbO₃ (Lithiumniobat), deren z - Achsen ebenfalls entlang der Scheibennormalen orientiert sind. Die gleichen Materialien können auch für plattenförmige Piezokörper 3 verwendet werden, wobei die Faser 4a entlang der z - Achse längserstreckt zu befestigen ist. Aus PVDF oder einer piezoelektrischen Keramik kann zudem auch eine Platte senkrecht zur z - Achse geschnitten und die Faser 4a in der Plattenebene längserstreckt 4a angebracht werden.

Der Verstärkungsfaktor eines Sensorelementes 2 ist, für eine gegebene E - Feldstärke bzw. Spannung, proportional zu einer über die Faserlänge gemittelten piezoelektrisch induzierten Dehnung des Körpers 3 und zur Faserlänge selber. Daher ist er eine Funktion von Material, kristallographischer Orientierung und Grösse des Piezokörpers 3 sowie von der Art der Faserbefestigung. Längenproportionale Verstärkungsfaktoren werden am einfachsten mit identisch aufgebauten, aber nicht notwendigerweise gleich langen Sensorelementen 2 realisiert.

Aus dielektrischen Gründen ist es wünschenswert, jedoch nicht notwendig, dass die Abstandselemente 5 eine zylindrische Gestalt haben und mit ihrer Achse C entlang der Sensorachse A ausgerichtet sind. Ihr Durchmesser darf von dem der Sensorelemente 2 abweichend, insbesondere kleiner, gewählt sein.

Vorzugsweise bestehen alle piezoelektrischen Körper 3 aus Quarz, wobei alle Quarzkörper 3 mit ihrer kristallographischen x - Achse entlang der Sensorachse A ausgerichtet und gleich orientiert sind. Jedes Sensorelement 2 kann mehrere Quarzkörper 3 und dielektrisch isolierende, nicht piezoelektrische Zwischen- und Endstücke aufweisen. Dadurch lassen sich aus kurzen Quarzen 3 relativ lange Sensorelemente 2 aufbauen. Bevorzugt weist jedes Sensorelement 2 genau einen Quarzkörper 3 auf, der aus mehreren Quarzstücken zusammengesetzt oder einstückig sein kann. Günstigerweise entfallen auch die Endstücke, so dass jeder Quarzkörper 3 und vorzugsweise auch die daran befestigte Sensorfaser 4a die ganze Länge des zugehörigen Sensorelementes 2 überbrücken. Jeder Quarzkörper 3 kann zylindrische, insbesondere kreiszylindrische, oder plattenförmige Gestalt haben, wobei eine Körperachse B, d. h. eine Zylinderachse B oder eine Achse B in der Plattenebene, parallel zur x - Achse orientiert ist. Die Faser 4a kann auf den Zylinder gewickelt oder am Zylinder, im Innern eines Hohlzylinders oder an der Platte in x - Richtung längserstreckt befestigt sein. Bei einer Längserstreckung der Faser in x - Richtung darf der Quarzdurchmesser beliebig klein gewählt sein. Im Falle der Wicklung ist der minimale Quarzdurchmesser durch den kleinsten zulässigen Krümmungsradius der aufgewickelten Faser 4a begrenzt. Die bewickelten Quarzzylinder 3 dürfen unterschiedliche Durchmesser aufweisen, sofern die Ganghöhe der Bewicklung proportional zum Durchmesser angepasst wird, d. h. sofern der Steigungswinkel der Bewicklung konstant gehalten wird. Dann sind die Verstärkungsfaktoren wiederum proportional zur Länge der Sensorelemente 2. Insbesondere weisen alle Quarzzylinder 3 genau einen vorgebbaren Durchmesser auf und ist die Sensorfaser 4a auf dem Umfang jedes Quarzzylinders 3 mit einer konstanten, vorgebbaren Ganghöhe aufgewickelt.

Insgesamt offenbart die Erfindung einen faseroptischen Spannungssensor 1, der aufgrund seines Aufbaus als langgestreckter, E - Feld integrierender, kapazitiver Spannungsteiler und seiner mit der Faseroptik kompatiblen dielektrischen Verpackung hervorragend für präzise Hochspannungsmessungen unter Freiluftbedingungen geeignet ist.

### BEZUGSZEICHENLISTE

- 1: faseroptischer Spannungssensor (Innenaufbau)
- 1a, 1b: Anschlusskontakte
- 2, 5: Sensoranordnung
- 2: Sensorelemente
- 2a, 2b: Endflächen der Sensorelemente
- 3: Quarzzylinder, piezolektrische Körper
- 4a, 4b: Glasfaser
- 4a: Zweimodenfaser, Sensorfaser
- 4b: Einmodenfaser, Verbindungsfaser
- 4c: Spleiss
- 5: Metallzylinder, Abstandselemente
- 6: Halterungen
- 7: optoelektronische Messapparatur
- 8: Erdpotential
- 9: Hochspannungspotential
- 10: Innenelektrode
- 11: Zwischenplatte
- 12: Steuerelektrode
- 13: Federelement
- 14: Aussparung
- 15: Hochspannungsteil
- 16: Isolatorrohr
- 17: Silikonschirm, Schutzbeschirmung
- 18: Polyurethan - Vergussmasse, Elastomer
- 19: Halterungsstifte
- 20: Isolatorstab
- 21: Silikonkörper, Elastomer
- 22: Fixierungen
- 23: Transformatorenöl, Silikonöl, Isolatorflüssigkeit
- 24: Faltenbalg, Druckausgleichselement
- 25: hochspannungsseitiger Flansch
- 26: erdseitiger Flansch
- 27: Koronaringe, Potentialsteuerungsringe
- 28: Faserstecker, Faserdurchführungen
- 29: Äquipotentiallinien
- 30: Hochspannungsfreiluftschalter
- 31: Stromleiter
- 32: Hochspannungsmast
- 33: Aufhängevorrichtung
- 34: Erdungs- und Verankerungskabel
- 35: erdseitiges Faserkabel (für Spannungs- und Stromsensor)
- 36: Faserstauraum
- 37: hochspannungsseitiges Faserkabel (für Stromsensor)
- 38: (hybrid-) optischer Stromsensor

- A: Sensorachse
- B: Längsachsen der Sensorelemente
- C: Längsachsen der Abstandselemente
- x: kristallographische x - Achse der Quarzzylinder
- L: Gesamtlänge des Spannungssensors
- lᵢ: Länge des i - ten Sensorelementes (i= 1, ..., n)
- dⱼ: Länge des j - ten Abstandselementes (j= 1, ..., n+1)
- n: Anzahl Sensorelemente

## Patentansprüche

1. Faseroptischer Spannungssensor (1) zur Hochspannungsmessung, mit zwei Anschlusskontakten (1a,1b) und einer sich da zwischen erstrecken den Sensorachse (A), wobei
a) der Spannungssensor (1) mindestens zwei E - Feld integrierende Sensorelemente (2), umfassend piezoelektrische Körper (3) und eine daran befestigte Sensorfaser (4a), sowie mehrere Abstandselemente (5) aufweist,
b) die Sensorelemente (2) und die Abstandselemente (5) alternierend und hintereinander entlang der Sensorachse (A) angeordnet und mechanisch gekoppelt sind,
c) die Abstandselemente (5) elektrisch leitfähig sind und mit jedem benachbarten Sensorelement (2) elektrisch kontaktiert sind,
d) zur Bildung eines freilufttauglichen Hochspannungsteils (15) des Spannungssensors (1) die Anordnung der Sensor- und Abstandselemente (2, 5) von einem hochspannungsfesten Dielektrikum (18, 21, 23) umgeben und mit einer Schutzbeschirmung (16, 17, 20, 21) versehen ist,
e) die Sensorachse (A) sich vom Erdpotential (8) bis zum Hochspannungspotential (9) erstreckt und
f) der Spannungssensor (1) zur Messung von Spannungen von mehreren 100 kV in Freilufthochspannungsanlagen ausgelegt ist.

2. Faseroptischer Spannungssensor (1) nach Anspruch 1, **dadurch gekennzeichnet, dass**
a) in jedem Sensorelement (2) die Sensorfaser (4a) mit einem vorgebbaren Längenabschnitt so an dem Körper (3) befestigt ist, dass sie Längenänderungen nur durch E - Feldkomponenten parallel zur Sensorachse (A) erfährt und
b) jedes Sensorelement (2) einen zu seiner Länge proportionalen Verstärkungsfaktor besitzt, welcher der piezoelektrisch induzierten Längenänderung der Sensorfaser (4a) entspricht.

3. Faseroptischer Spannungssensor (1) nach Anspruch 2, **dadurch gekennzeichnet, dass**
a) die Sensor- und Abstandselemente (2,5) zylindrische Gestalt haben und mit ihren Achsen (B, C) entlang der Sensorachse (A) ausgerichtet sind und
b) zwischen benachbarten Sensor- und Abstandselementen (2, 5) elektrisch leitfähige, flexible Halterungen (6) vorgesehen sind.

4. Faseroptischer Spannungssensor (1) nach Anspruch 3, **dadurch gekennzeichnet, dass**
a) die Halterungen (6) Innenelektroden (10), Steuerelektroden (12) und Federelemente (13) aufweisen,
b) die Innenelektroden mit den Endflächen (2a, 2b) der Sensorelemente (2) in einer form- und stoffschlüssigen Verbindung stehen,
c) die Steuerelektroden (12) an den Innenelektroden (10) befestigt sind und
d) die Federelemente (13) die Innenelektroden (10) mit den benachbarten Abstandselementen (5) verbinden.

5. Faseroptischer Spannungssensor (1) nach einem der Ansprüche 1 - 4, **dadurch gekennzeichnet, dass**
a) das Dielektrikum aus einem Elastomer (18, 21) oder einer Isolatorflüssigkeit (23) besteht und
b) die Schutzbeschimung (16, 17, 20, 21) aus einem Elastomer (17, 21) besteht und zusätzlich einen Stützisolator (16, 20) umfasst.

6. Faseroptischer Spannungssensor (1) nach Anspruch 5, **dadurch gekennzeichnet, dass**
a) das Dielektrikum aus einer Polyurethan - Vergussmasse (18) besteht,
b) die Schutzbeschirmung aus einer Silikon - Vergussmasse in der Form eines gerippten Silikonschirms (17) besteht und
c) der Silikonschirm (17) auf einem Isolatorrohr (16) aus einem faserverstärkten Kunststoff sitzt.

7. Faseroptischer Spannungssensor (1) nach Anspruch 5, **dadurch gekennzeichnet, dass**
a) das Dielektrikum und die Schutzbeschirmung aus einer Silikon - Vergussmasse in der Form eines gerippten Silikonkörpers (21) bestehen und
b) der Silikonkörper (21) zusätzlich mindestens einen Isolatorstab (20) aus einem faserverstärkten Kunststoff aufweist.

8. Faseroptischer Spannungssensor (1) nach Anspruch 5, **dadurch gekennzeichnet, dass**
a) das Dielektrikum ein Transformatoren- oder Silikonöl (23) ist,
b) die Schutzbeschirmung aus einer Silikon - Vergussmasse in der Form eines gerippten Silikonschirms (17) besteht,
c) der Silikonschirm (17) auf einem Isolatorrohr (16) aus einem faserverstärkten Kunststoff sitzt und
d) ein Druckausgleichselement (24) für das Öl (23) und öldichte Faserdurchführungen (28) vorgesehen sind.

9. Faseroptischer Spannungssensor (1) nach einem der Ansprüche 5 - 8, **dadurch gekennzeichnet, dass** der Hochspannungsteil (15) Anschlusskontakte (1a, 1 b) in der Form von Flanschen (25,26), eine Aufhängevorrichtung (33), mindestens einen Korona- und/oder Potentialsteuerungsring (27) und ein Erdungs- und Verankerungskabel (34) aufweist.

10. Faseroptischer Spannungssensor (1) nach Anspruch 9, **dadurch gekennzeichnet, dass**
a) der erdseitige Flansch (26) Faserstecker (28) und der hochspannungsseitige Flansch (25) einen Faserstauraum (36) aufweist,
b) zusätzlich ein potentialgetrennter Stromsensor (38) vorgesehen ist, für den optische Zuführungsfasern im Hochspannungsteil (15) mitvergossen sind und
c) freihängende Faserkabel (35, 37) zwischen dem Stromsensor (38) und dem hochspannungsseitigen Flansch (25) und zwischen dem erdseitigen Flansch (26) und einer Messapparatur (7) vorgesehen sind.

11. Faseroptischer Spannungssensor (1) nach Anspruch 10, **dadurch gekennzeichnet, dass**
a) eine Gesamtlänge und ein Durchmesser des Hochspannungsteils (15) sowie eine Anzahl, Länge, Position und ein Durchmesser der Sensorelemente (2) nach Massgabe einer Hochspannungsklasse des Spannungssensors (1) gewählt sind und
b) insbesondere die Länge der Sensorelemente (2) gleich und ihre Abstände zum Erdpotential (9) hin zunehmend gewählt sind.

12. Faseroptischer Spannungssensor (1) nach Anspruch 11, **dadurch gekennzeichnet, dass**
a) alle piezoelektrischen Körper (3) aus Quarz bestehen und alle Quarzkörper (3) mit ihrer kristallographischen x - Achse entlang der Sensorachse (A) ausgerichtet und gleich orientiert sind.

13. Faseroptischer Spannungssensor (1) nach Anspruch 12, **dadurch gekennzeichnet, dass**
a) jedes Sensorelement (2) genau einen zylindrischen Quarzkörper (3) aufweist, der vorzugsweise einstückig ist und
b) jeder Quarzzylinder (3) und die daran befestigte Sensorfaser (4a) die ganze Länge des zugehörigen Sensorelementes (2) überbrückten.

14. Faseroptischer Spannungssensor (1) nach Anspruch 13, **dadurch gekennzeichnet, dass**
a) alle Quarzzylinder (3) genau einen vorgebbaren Durchmesser aufweisen,
b) die Sensorfaser (4a) auf dem Umfang jedes Quarzzylinders (3) mit einer konstanten, vorgebbaren Ganghöhe aufgewickelt ist und
c) die Sensorfaser (4a) eine Zweimodenfaser (4a) ist, die über eine Einmoden - Verbindungsfaser (4b) mit einer Zweimoden - Empfangsfaser nach Art eines Tandem - Interferometers zusammengeschaltet ist.

## Claims

1. Fibre-optic voltage sensor (1) for high-voltage measurement, having two connector contacts (1a, 1b) and a sensor axis (A) extending therebetween, in which
a) the voltage sensor (1) has at least two E-field integrating sensor elements (2) comprising piezoelectric bodies (3) and a sensor fibre (4a) fastened thereto, as well as several spacing elements (5),
b) the sensor elements (2) and the spacing elements (5) are arranged in an alternating fashion and one behind another along the sensor axis (A) and are mechanically coupled,
c) the spacing elements (5) are electrically conductive and make electric contact with each neighbouring sensor element (2),
d) in order to form a high-voltage part (15) of the voltage sensor (1) which can be used outdoors, the arrangement of the sensor elements (2) and spacing elements (5) is surrounded by a high-voltage-proof dielectric (18, 21, 23) and is provided with a protective shield (16, 17, 20, 21),
e) the sensor axis (A) extends from ground potential (8) as far as high-voltage potential (9), and
f) the voltage sensor (1) is designed for measuring voltages of several 100 kV in outdoor high-voltage installations.

2. Fibre-optic voltage sensor (1) according to Claim 1, **characterized in that**
a) in each sensor element (2) the sensor fibre (4a) is fastened with a prescribable length section to the body (3) such that it experiences changes in length only by virtue of E-field components parallel to the sensor axis (A) and
b) each sensor element (2) has a gain which is proportional to its length and corresponds to the piezoelectrically induced change in length of the sensor fibre (4a).

3. Fibre-optic voltage sensor (1) according to Claim 2, **characterized in that**
a) the sensor elements (2) and spacing elements (5) are of cylindrical configuration and are aligned with their axes (B, C) along the sensor axis (A), and
b) electrically conductive, flexible holders (6) are provided between neighbouring sensor elements (2) and spacing elements (5).

4. Fibre-optic voltage sensor (1) according to Claim 3, **characterized in that**
a) the holders (6) have inner electrodes (10), control electrodes (12) and spring elements (13),
b) the inner electrodes are connected in a self-closed and bonded fashion to the end faces (2a, 2b) of the sensor elements (2),
c) the control electrodes (12) are fastened to the inner electrodes (10), and
d) the spring elements (13) connect the inner electrodes (10) to the neighbouring spacing elements (5).

5. Fibre-optic voltage sensor (1) according to one of Claims 1-4, **characterized in that**
a) the dielectric consists of an elastomer (18, 21) or an insulating liquid (23) and
b) the protective shield (16, 17, 20, 21) consists of an elastomer (17, 21) and additionally comprises a post insulator (16, 20).

6. Fibre-optic voltage sensor (1) according to Claim 5, **characterized in that**
a) the dielectric consists of a polyurethane sealing compound (18),
b) the protective shield consists of a silicone sealing compound in the form of a ribbed silicone shield (17), and
c) the silicone shield (17) is seated on an insulating tube (16) made from a fibre-reinforced plastic.

7. Fibre-optic voltage sensor (1) according to Claim 5, **characterized in that**
a) the dielectric and the protective shield consist of a silicone sealing compound in the form of a ribbed silicone body (21) and
b) the silicone body (21) additionally has at least one insulating bar (20) made from a fibre-reinforced plastic.

8. Fibre-optic voltage sensor (1) according to Claim 5, **characterized in that**
a) the dielectric is a transformer or silicone oil (23),
b) the protective shield consists of a silicone sealing compound in the form of a ribbed silicone shield (17),
c) the silicone shield (17) is seated on an insulating tube (16) made from a fibre-reinforced plastic, and
d) a pressure compensation element (24) for the oil (23) and oil-tight fibre bushings (28) are provided.

9. Fibre-optic voltage sensor (1) according to one of Claims 5-8, **characterized in that** the high-voltage part (15) has connector contacts (1a, 1b) in the form of flanges (25, 26), a suspension device (33), at least one corona and/or potential control ring (27) and a grounding and anchoring cable (34).

10. Fibre-optic voltage sensor (1) according to Claim 9, **characterized in that**
a) the flange (26) at the ground end has fibre plugs (28), and the flange (25) at the high-voltage end has a fibre stowage space (36),
b) in addition, an isolated current sensor (38) is provided, for which optical feed fibres are also sealed in the high-voltage part (15), and
c) freely suspended fibre cables (35, 37) are provided between the current sensor (38) and the flange (25) at the high-voltage end, and between the flange (26) at the ground end and a measurement apparatus (7).

11. Fibre-optic voltage sensor (1) according to Claim 10, **characterized in that**
a) a total length and a diameter of the high-voltage part (15), as well as a number, length, position and a diameter of the sensor elements (2) are selected in accordance with a high-voltage class of the voltage sensor (1), and
b) in particular, the length of the sensor elements (2) is selected to be equal, and their spacings are selected to increase relative to ground potential (9).

12. Fibre-optic voltage sensor (1) according to Claim 11, **characterized in that**
a) all the piezoelectric bodies (3) consist of quartz, and all the quartz bodies (3) are aligned with their crystallographic x-axis along the sensor axis (A) and are identically orientated.

13. Fibre-optic voltage sensor (1) according to Claim 12, **characterized in that**
a) each sensor element (2) has precisely one cylindrical quartz body (3) which is preferably unipartite, and
b) each quartz cylinder (3) and the sensor fibre (4a) fastened thereto bridge the entire length of the associated sensor element (2).

14. Fibre-optic voltage sensor (1) according to Claim 13, **characterized in that**
a) all the quartz cylinders (3) have precisely one prescribable diameter,
b) the sensor fibre (4a) is wound on the circumference of each quartz cylinder (3) with a constant, prescribable lead, and
c) the sensor fibre (4a) is a double-mode fibre (4a) which is interconnected via a monomode connecting fibre (4b) to a double-mode receiving fibre in the manner of a tandem interferometer.

## Revendications

1. Sonde de tension (1) à fibres optiques pour la mesure de hautes tensions, dotée de deux bornes de contact (1a, 1b) entre lesquelles s'étend un axe (A) de détecteur,
a) le détecteur de tension (1) présentant au moins deux éléments de détecteur (2) intégrant le champ électrique et comprenant des corps piézoélectriques (3) auxquels sont fixées des fibres de détecteur (4a), ainsi que plusieurs éléments d'écartement (5),
b) les éléments de détecteur (2) et les éléments d'écartement (5) étant disposés en alternance et l'un à la suite de l'autre suivant l'axe (A) du détecteur et étant accouplés mécaniquement,
c) les éléments d'écartement (5) étant électriquement conducteurs et étant en contact électrique avec chaque élément de détecteur (2) voisin,
d) pour former une partie (15) à haute tension à l'air libre du détecteur de tension (1), l'agencement des éléments de détecteur et des éléments d'écartement (2, 5) est entouré par un diélectrique (18, 21, 23) résistant aux hautes tensions et est doté d'un blindage de protection (16, 17, 20, 21),
e) l'axe (A) du détecteur s'étendant entre le potentiel de terre (8) et le potentiel (9) de la haute tension et
f) le détecteur de tension (1) étant conçu pour mesurer des tensions de plus de 100 kV dans des installations à haute tension situées à l'air libre.

2. Sonde de tension (1) à fibres optiques selon la revendication 1, **caractérisée en ce que**
a) dans chaque élément de détecteur (2), la fibre de détection (4a) est fixée sur le corps (3) par un tronçon de longueur prédéterminée de telle sorte que les variations de tension qu'elle subit suite à l'effet des composantes du champ électrique soient uniquement parallèles à l'axe (A) du détecteur et **en ce que**
b) chaque élément de détecteur (2) possède un facteur d'épaississement proportionnel à sa longueur, qui correspond à la modification induite piézoélectriquement de la longueur de la fibre de détection (4a).

3. Sonde de tension (1) à fibres optiques selon la revendication 2, **caractérisée en ce que**
a) les éléments de détecteur et les éléments d'écartement (2, 5) ont une forme cylindrique et leurs axes (B, C) sont orientés parallèlement à l'axe (A) du détecteur et **en ce que**
b) des fixations (6) flexibles et électriquement conductrices sont prévues entre des éléments de détecteur et des éléments d'écartement (2, 5) voisins.

4. Sonde de tension (1) à fibres optiques selon la revendication 3, **caractérisée en ce que**
a) les supports (6) présentent des électrodes intérieures (10), des électrodes de commande (12) et des éléments élastiques (13), **en ce que**
b) les électrodes intérieures sont reliées géométriquement et matériellement aux surfaces d'extrémité (2a, 2b) des éléments de détecteur (2), **en ce que**
c) les électrodes de commande (12) sont fixées sur les électrodes intérieures (10) et **en ce que**
d) les éléments élastiques (13) relient les électrodes intérieures (10) aux éléments d'écartement (5) voisins.

5. Sonde de tension (1) à fibres optiques selon l'une des revendications 1 à 4, **caractérisée en ce que**
a) le diélectrique est constitué d'un élastomère (18, 21) ou d'un liquide isolant (23) et **en ce que**
b) le blindage de protection (16, 17, 20, 21) est constitué d'un élastomère (17, 21) et comprend de plus un isolateur de soutien (16, 20).

6. Sonde de tension (1) à fibres optiques selon la revendication 5, **caractérisée en ce que**
a) le diélectrique est constitué d'une pâte de moulage (18) en polyuréthane, **en ce que**
b) le blindage de protection est constitué d'une pâte de coulée en silicone qui présente la forme d'un blindage nervuré (17) en silicone et **en ce que**
c) le blindage (17) en silicone est placé sur un tube (16) d'isolateur constitué d'une matière synthétique renforcée de fibres.

7. Sonde de tension (1) à fibres optiques selon la revendication 5, **caractérisée en ce que**
a) le diélectrique et le blindage de protection sont constitués d'une pâte de coulée en silicone qui présente la forme d'un corps nervuré (21) en silicone et **en ce que**
b) le corps (21) en silicone présente en plus au moins un barreau d'isolateur (20) en matière synthétique renforcée de fibres.

8. Sonde de tension (1) à fibres optiques selon la revendication 5, **caractérisée en ce que**
a) le diélectrique est une huile (23) pour transformateur ou de silicone, **en ce que**
b) le blindage de protection est constitué d'une pâte de coulée en silicone et présente la forme d'un blindage nervuré (17) en silicone, **en ce que**
c) le blindage en silicone (17) est placé sur un tube (16) d'isolateur en matière synthétique renforcée de fibres et **en ce que**
d) un élément (24) d'égalisation de pression de l'huile (23) et des passages (28) étanches à l'huile pour les fibres sont prévus.

9. Sonde de tension (1) à fibres optiques selon l'une des revendications 5 à 8, **caractérisé en ce que** la partie (15) à haute tension présente des bornes de contact (1a, 1b) qui présentent la forme de brides (25, 26), un dispositif de suspension (33), au moins un anneau (27) de contrôle de l'effet corona et/ou du potentiel et un câble (34) de mise à la terre et d'ancrage.

10. Sonde de tension (1) à fibres optiques selon la revendication 9, **caractérisée en ce que**
a) la bride (26) située côté terre présente des connecteurs (28) de fibres et la bride (25) située côté haute tension un espace (36) d'accumulation de fibres, **en ce que**
b) un détecteur de courant (38) séparé du potentiel pour lequel les fibres optiques d'amenée sont coulées conjointement dans la pièce (15) à haute tension est prévu en supplément et **en ce que**
c) des câbles (35, 37) de fibres, suspendus librement, sont prévus entre le détecteur de courant (38) et la bride (25) située du côté haute tension et entre la bride (26) située côté terre et un appareil de mesure (7).

11. Sonde de tension (1) à fibres optiques selon la revendication 10, **caractérisée en ce que**
a) la longueur totale et le diamètre de la partie (15) à haute tension ainsi que le nombre, la longueur, la position et le diamètre des éléments de détecteur (2) sont sélectionnés en fonction de la classe de haute tension du détecteur de tension (1) et **en ce que**
b) en particulier, les longueurs sélectionnées pour les éléments de détecteur (2) sont identiques et leur distance sélectionnée par rapport au potentiel de terre (9) augmente.

12. Sonde de tension (1) à fibres optiques selon la revendication 11, **caractérisée en ce que**
a) tous les corps piézoélectriques (3) sont constitués de quartz et tous les corps de quartz (3) ont leur axe cristallographique x orienté suivant l'axe (A) du détecteur et ont la même orientation.

13. Sonde de tension (1) à fibres optiques selon la revendication 12, **caractérisée en ce que**
a) chaque élément de détecteur (2) présente exactement un corps (3) cylindrique en quartz, de préférence d'une seule pièce et **en ce que**
b) chaque cylindre (3) en quartz et la fibre de détection (4a) qui y est fixée couvrent la même longueur de l'élément de détecteur (2) qui leur est associé.

14. Sonde de tension (1) à fibres optiques selon la revendication 13, **caractérisé en ce que**
a) tous les cylindres (3) en quartz présentent un diamètre prédéterminé avec précision, **en ce que**
b) la fibre de détection (4a) est enroulée à la périphérie de chaque cylindre (3) en quartz à un pas constant et prédéterminé et **en ce que**
c) la fibre de détection (4a) est une fibre bimodale (4a) qui est constituée du raccordement d'une fibre unimodale de liaison (4b) et de fibres bimodales de réception, à la manière d'un interféromètre tandem.
